# EUROPEAN PATENT SPECIFICATION

(11) **EP 4 280 846 B1**
(45) Date of publication and mention of the grant of the patent: **01.04.2026**
(21) Application number: 23172951.8
(22) Date of filing: 11.05.2023
(51) Int. Cl.: H10K 59/121, H10K 59/131

(54) **DISPLAY APPARATUS**
ANZEIGEGERÄT
APPAREIL D'AFFICHAGE

(30) Priority: 16.05.2022 KR 20220059848; 11.07.2022 KR 20220085274
(43) Date of publication of application: 22.11.2023
(73) Proprietor: Samsung Display Co., Ltd., Yongin-si, Gyeonggi-do 17113 (KR)
(72) Inventor: LEE, Dongmin, 17113 Yongin-si (KR); SHIN, Hyuneok, 17113 Yongin-si (KR); PARK, Joonyong, 17113 Yongin-si (KR); SUNG, Hyunah, 17113 Yongin-si (KR); JEONG, Samtae, 17113 Yongin-si (KR)
(74) Representative: Marks & Clerk LLP

(56) References cited:
- EP-A1- 3 331 046
- EP-A1- 3 496 148
- EP-A1- 4 246 574

## Description

### BACKGROUND

### 1. Field

One or more embodiments relate to a display apparatus.

### 2. Description of the Related Art

A display apparatus includes a display element and a transistor electrically connected to the display element. A connection electrode is electrically connected to a semiconductor layer of a transistor and configured to transfer electrical signals to the transistor (see, for example, EP3496148 A1, EP3331046 A1 and EP4246574 A1). However, the connection electrode may be damaged during a subsequent process after the connection electrode is formed.

### SUMMARY

One or more embodiments include a display apparatus including a high-quality connection electrode which is not damaged during a subsequent process after the connection electrode is formed and in which electrical characteristics are not deteriorated. However, such a technical problem is an example, and the disclosure is not limited thereto.

Additional aspects will be set forth in part in the description which follows and, in part, will be apparent from the description, or may be learned by practice of the presented embodiments of the disclosure.

According to the claimed invention, a display apparatus includes: a substrate including a display area and a peripheral area outside the display area; a display element arranged in the display area, a transistor including a semiconductor layer and a gate electrode; and a connection electrode electrically connected to the transistor and having a multi-layered structure, where the connection electrode includes: a main metal layer including a first metal element; and a first protective layer disposed on the main metal layer and including the first metal element and a second metal element different from the first metal element. The connection electrode further comprises an oxide metal layer disposed on the first protective layer and including a metal oxide including the first metal element and the second metal element.

The first metal element may include at least one of copper (Cu), aluminium (Al), platinum (Pt), silver (Ag), gold (Au), and nickel (Ni).

The second metal element may include at least one of titanium (Ti), molybdenum (Mo), and tungsten (W).

The first protective layer may include an alloy of copper (Cu) and titanium (Ti).

The display apparatus may further include an auxiliary layer disposed under the main metal layer.

The auxiliary layer may include the second metal element.

The auxiliary layer may include an auxiliary layer tip further protruding in a lateral direction than the main metal layer at a border between the auxiliary layer and the main metal layer.

The auxiliary layer may further include the first metal element.

The semiconductor layer may be disposed on the substrate, the gate electrode may be disposed on a gate insulating layer disposed on the semiconductor layer, and the connection electrode may be electrically connected to the semiconductor layer.

A second protective layer may be disposed between the main metal layer and the first protective layer and including the second metal element.

The semiconductor layer may be disposed on the substrate, the gate electrode may be disposed on a gate insulating layer disposed on the semiconductor layer, and the connection electrode may be electrically connected to the semiconductor layer.

At least some of the above and other features of the invention are set out in the claims.

These and/or other aspects will become apparent and more readily appreciated from the following detailed description of the embodiments, the accompanying drawings, and claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view of a display apparatus according to an embodiment;
FIG. 2 is an equivalent circuit diagram of a pixel of a display apparatus according to an embodiment;
FIG. 3 is a schematic cross-sectional view of a display apparatus, taken along line I-I' of FIG. 1;
FIGS. 4 to 6 are schematic cross-sectional views showing a process of manufacturing a portion of the display apparatus of FIG. 3;
FIG. 7 is a schematic enlarged cross-sectional view of a region II of a display apparatus of FIG. 3;
FIG. 8 is a schematic enlarged cross-sectional view of a region III of a display apparatus of FIG. 7;
FIG. 9 is a cross-sectional view for explaining a first connection electrode of a display apparatus according to a comparative example;
FIG. 10 is a schematic cross-sectional view of a portion of a display apparatus according to an embodiment;
FIG. 11 is a schematic cross-sectional view of a portion of a display apparatus according to another embodiment;
FIG. 12 is a schematic enlarged cross-sectional view of a region IV of a display apparatus of FIG. 11;
FIG. 13 is a schematic enlarged cross-sectional view of a region V of a display apparatus of FIG. 12;
FIGS. 14 to 16 are schematic cross-sectional views showing a process of manufacturing a portion of the display apparatus of FIG. 11; and
FIG. 17 is a view for explaining a portion of a second protective layer-forming layer that contacts etchant while patterning is performed.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present disclosure allows for various changes and numerous embodiments, certain embodiments will be illustrated in the drawings and described in the written description. Effects and features of the disclosure, and methods for achieving them will be clarified with reference to embodiments described below in detail with reference to the drawings. However, the disclosure is not limited to the following embodiments and may be embodied in various forms.

Hereinafter, embodiments will be described with reference to the accompanying drawings, wherein like reference numerals refer to like elements throughout and a repeated description thereof is omitted.

As used herein, when various elements such as a layer, a region, a plate, and the like are disposed "on" another element, not only the elements may be disposed "directly on" the other element, but another element may be disposed therebetween. In addition, sizes of elements in the drawings may be exaggerated or reduced for convenience of explanation. As an example, the size and thickness of each element shown in the drawings are arbitrarily represented for convenience of description, and thus, the present disclosure is not necessarily limited thereto.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

While such terms as "first" and "second" may be used to describe various components, such components must not be limited to the above terms. The above terms are used to distinguish one component from another.

The singular forms "a," "an," and "the" as used herein are intended to include the plural forms as well unless the context clearly indicates otherwise.

It will be understood that the terms "comprise," "comprising," "include" and/or "including" as used herein specify the presence of stated features or components but do not preclude the addition of one or more other features or components.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

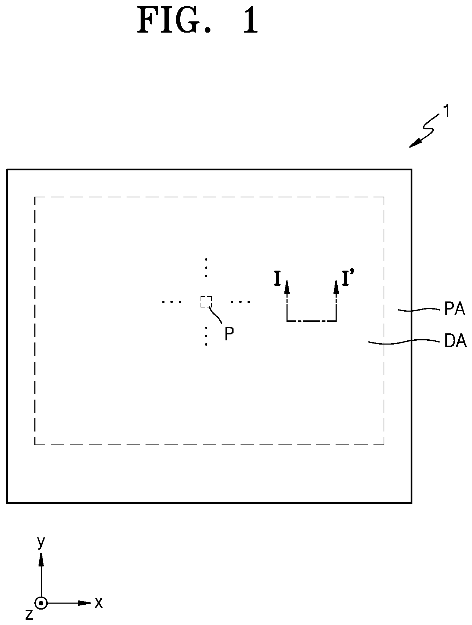

FIG. 1 is a schematic plan view of a display apparatus 1 according to an embodiment. Here, the "plan view" is a view in the thickness direction (i.e., z direction) of the display apparatus or the substrate 100. As shown in FIG. 1, the display apparatus 1 includes a display area DA and a peripheral area PA, wherein a plurality of pixels P are arranged in the display area DA, and the peripheral area PA is outside the display area DA. Specifically, the peripheral area PA may surround the entirety of the display area DA.

Each pixel P of the display apparatus 1 is a region that may be configured to emit light of a preset color. The display apparatus 1 may be configured to display images by using light from the pixels P. As an example, each pixel P may be configured to emit red, green, or blue light.

As shown in FIG. 1, the display area DA may have a polygonal shape including a quadrangular shape. As an example, the display area DA may have a rectangular shape in which a horizontal length thereof is greater than a vertical length, a rectangular shape in which a horizontal length thereof is less than a vertical length, or a square shape. Alternatively, the display area DA may have various shapes such as an elliptical shape or a circular shape.

The peripheral area PA may be a non-display area in which the pixels are not arranged. A driver and the like configured to provide electric signals or power to the pixels P may be arranged in the peripheral area PA. A plurality of pads (not shown) may be arranged in the peripheral area PA, wherein the pads are a region to which electronic elements or a printed circuit board may be electrically connected. The pads may be apart from each other in the peripheral area PA and electrically connected to a printed circuit board or an integrated circuit element.

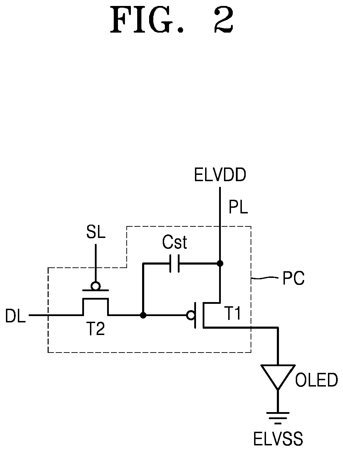

FIG. 2 is an equivalent circuit diagram of a pixel of the display apparatus 1 according to an embodiment. As shown in FIG. 2, a pixel P may include a pixel circuit PC and an organic light-emitting diode OLED electrically connected to the pixel circuit PC.

The pixel circuit PC may include a first transistor T1, a second transistor T2, and a storage capacitor Cst. The second transistor T2 is a switching transistor, may be connected to a scan line SL and a data line DL, and configured to transfer a data voltage to the first transistor T1 according to a switching voltage, the data voltage being input from the data line DL, and the switching voltage being input from the scan line SL. The storage capacitor Cst may be connected to the second transistor T2 and a driving voltage line PL and configured to store a voltage corresponding to a difference between a voltage transferred from the second transistor T2 and a first power voltage ELVDD supplied to the driving voltage line PL.

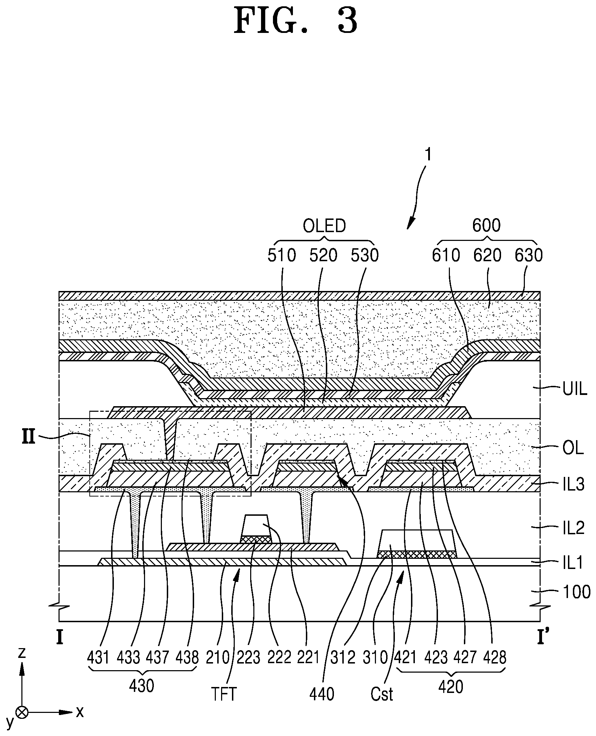

The first transistor T1 is a driving transistor, may be connected to the driving voltage line PL and the storage capacitor Cst, and configured to control a driving current according to the voltage stored in the storage capacitor Cst, the driving current flowing from the driving voltage line PL to the organic light-emitting diode OLED. The organic light-emitting diode OLED may emit light having a preset brightness corresponding to the driving current. An opposite electrode 530 (see FIG. 3) of the organic light-emitting diode OLED may receive a second power voltage ELVSS.

Though it is described with reference to FIG. 2 that the pixel circuit PC includes two transistors and one storage capacitor, the embodiment is not limited thereto. In another embodiment, the number of transistors and the number of storage capacitors may be variously changed according to the design of the pixel circuit PC.

FIG. 3 is a schematic cross-sectional view of the display apparatus 1 according to an embodiment. Specifically, FIG. 3 is a schematic cross-sectional view of the display apparatus 1, taken along line I-I' of FIG. 1.

As shown in FIG. 3, the display apparatus 1 according to an embodiment includes a substrate 100. The substrate 100 may include various flexible or bendable materials. As an example, the substrate 100 may include glass, metal, or a polymer resin. In addition, the substrate 100 may include a polymer resin such as polyethersulphone, polyacrylate, polyetherimide, polyethylene naphthalate, polyethylene terephthalate, polyphenylene sulfide, polyarylate, polyimide, polycarbonate, or cellulose acetate propionate. The substrate 100 may have a multi-layered structure including two layers each including the polymer resin, and a barrier layer including an inorganic material (such as silicon oxide, silicon nitride, and silicon oxynitride) therebetween. However, various modifications may be made.

A display element and a transistor TFT electrically connected to the display element may be located over the substrate 100. It is shown in FIG. 3 that the organic light-emitting diode OLED as a display element is located over the substrate 100. When the organic light-emitting diode OLED is electrically connected to the transistor TFT, it may be understood that a pixel electrode 510 is electrically connected to the transistor TFT.

The transistor TFT may include a semiconductor layer 221 and a gate electrode 222, where the semiconductor layer 221 includes amorphous silicon, polycrystalline silicon, an organic semiconductor material, or an oxide semiconductor material, and the gate electrode 222 overlaps a channel region of the semiconductor layer 221 in a plan view. The gate electrode 222 may include a conductive material including molybdenum (Mo), aluminium (Al), copper (Cu), titanium (Ti), or the like. As an example, the gate electrode 222 may have a multi-layered structure or a single-layered structure including the conductive materials. To secure insulation between the semiconductor layer 221 and the gate electrode 222, a gate insulating layer 223 may be disposed between the semiconductor layer 221 and the gate electrode 222, wherein the gate insulating layer 223 includes an inorganic material such as silicon oxide, silicon nitride, and/or silicon oxynitride. The insulating layer including the inorganic material may be formed by chemical vapor deposition ("CVD") or atomic layer deposition ("ALD"). This is also applicable to embodiments below and modifications thereof.

A second insulating layer IL2 may be disposed on the gate electrode 222, wherein the second insulating layer IL2 includes an inorganic material such as silicon oxide, silicon nitride, and/or silicon oxynitride. A first connection electrode 430 and a second connection electrode 440 may be disposed on the second insulating layer IL2. The first connection electrode 430 and the second connection electrode 440 may be electrically connected to the semiconductor layer 221 of the transistor TFT. Specifically, the first connection electrode 430 may be connected to a portion of the semiconductor layer 221, for example, a source region through a contact hole formed in the second insulating layer IL2. The second connection electrode 440 may be connected to another portion of the semiconductor layer 221, for example, a drain region through another contact hole formed in the second insulating layer IL2. As an example, the first connection electrode 430 may be a source electrode, and the second connection electrode 440 may be a drain electrode. Alternatively, the first connection electrode 430 may be a drain electrode, and the second connection electrode 440 may be a source electrode depending on the polarity of the transistor TFT.

However, the embodiment is not limited thereto. In another embodiment, the display apparatus 1 may include only one of the first connection electrode 430 and the second connection electrode 440. The first connection electrode 430 and the second connection electrode 440 may each have a multi-layered structure including a plurality of sub-layers. Specifically, the first connection electrode 430 may include a main metal layer 433, a first protective layer 437, an oxide metal layer 438, and an auxiliary layer 431, which are described below.

The storage capacitor Cst may include a first electrode 310 and a second electrode 420. The first electrode 310 of the storage capacitor Cst may be formed during the same process of forming the gate electrode 222 and may include the same material as a material of the gate electrode 222. An insulating layer 312 including the same material as a material of the gate insulating layer 223 may be disposed under the first electrode 310. Because the insulating layer 312 under the first electrode 310 is formed during the same mask process as a mask process of forming the first electrode 310, a planar shape of the insulating layer 312 may be substantially the same as a planar shape of the first electrode 310. The second electrode 420 may be formed together during a patterning process of forming the first connection electrode 430 and the second connection electrode 440. Accordingly, like the first connection electrode 430 and the second connection electrode 440, the second electrode 420 may have a multi-layered structure. The multi-layered structure is described below in detail.

The transistor TFT may include a lower metal layer 210 disposed below the semiconductor layer 221. The lower metal layer 210 may be electrically connected to one of the first connection electrode 430 and the second connection electrode 440. In an embodiment, it is shown in FIG. 3 that the lower metal layer 210 is electrically connected to the first connection electrode 430. The lower metal layer 210 may be a kind of lower first connection electrode.

The lower metal layer 210 may include at least one of aluminium (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), and copper (Cu). The lower metal layer 210 may improve a characteristic of the first connection electrode.

A first insulating layer IL1 may be disposed on the lower metal layer 210. Specifically, the first insulating layer IL1 may be formed on the entire surface of the substrate 100 to cover the lower metal layer 210. The first insulating layer IL1 may include, for example, an inorganic material such as silicon oxide, silicon nitride and/or silicon oxynitride. The first insulating layer IL1 may increase flatness of the upper surface of the substrate 100, or prevent or reduce impurities from the substrate 100 penetrating the semiconductor layer 221 of the transistor TFT.

The second insulating layer IL2 may be disposed on the gate electrode 222 and the first electrode 310. Specifically, the second insulating layer IL2 may be formed on the entire surface of the substrate 100 to cover the gate electrode 222 and the first electrode 310. Accordingly, the first connection electrode 430, the second connection electrode 440, and the second electrode 420 may be disposed on the second insulating layer IL2. The second insulating layer IL2 may include, for example, an inorganic material such as silicon oxide, silicon nitride and/or silicon oxynitride. Alternatively, the second insulating layer IL2 may include, for example, acryl, benzocyclobutene ("BCB"), or hexamethyldisiloxane ("HMDSO"). In this case, the upper surface (in a +z direction) of the second insulating layer IL2 may be planarized.

A third insulating layer IL3 may be disposed on the first connection electrode 430, the second connection electrode 440, and the second electrode 420. Specifically, the third insulating layer IL3 may be formed on the entire surface of the substrate 100 to cover the first connection electrode 430, the second connection electrode 440, and the second electrode 420. The third insulating layer IL3 may include, for example, an inorganic material such as silicon oxide, silicon nitride and/or silicon oxynitride.

An organic insulating layer OL may be disposed on the third insulating layer IL3. As an example, as shown in FIG. 3, in the case where the organic light-emitting diode OLED is disposed over the first connection electrode 430, the second connection electrode 440, and the second electrode 420, the organic insulating layer OL may generally planarize the upper portion of the protective layer covering the first connection electrode 430, the second connection electrode 440, and the second electrode 420. The organic insulating layer OL may include an organic material, for example, acryl, benzocyclobutene (BCB), or hexamethyldisiloxane (HMDSO). Though it is shown in FIG. 3 that the organic insulating layer OL is a single layer, the organic insulating layer OL may be a multi-layer. However, various modifications may be made.

A display element may be located on the organic insulating layer OL. For a display element, the organic light-emitting diode OLED shown in FIG. 3 may be used. The organic light-emitting diode OLED may include, for example, the pixel electrode 510, the opposite electrode 530, and an intermediate layer 520 therebetween, wherein the intermediate layer 520 includes an emission layer. The pixel electrode 510 may be electrically connected to the transistor TFT. Specifically, as shown in FIG. 3, the pixel electrode 510 may be connected to the first connection electrode 430 or the second connection electrode 440 through a contact hole formed in the organic insulating layer OL. The first connection electrode 430 or the second connection electrode 440 may be electrically connected to the transistor TFT. The pixel electrode 510 includes a light-transmissive conductive layer and a reflective layer, wherein the light-transmissive conductive layer includes a light-transmissive conductive oxide such as indium tin oxide ("ITO"), indium oxide (In₂O₃), or indium zinc oxide ("IZO"), and the reflective layer includes metal such as aluminium (Al) or silver (Ag). As an example, the pixel electrode 510 may have a three-layered structure of ITO/Ag/ITO.

The intermediate layer 520 of the organic light-emitting diode OLED may include a low-molecular weight material or a polymer material. In the case where the intermediate layer 520 includes a low molecular weight material, the intermediate layer 520 may have a structure in which a hole injection layer ("HIL"), a hole transport layer ("HTL"), an emission layer ("EML"), an electron transport layer ("ETL"), an electron injection layer ("EIL"), etc. are stacked in a single or composite configuration. The intermediate layer 520 may include various organic materials such as copper phthalocyanine (CuPc), N,N'-di(naphthalene-1-yl)-N,N'-diphenyl-benzidine ("NPB"), and tris-8-hydroxyquinoline aluminium (Alq3). These layers may be formed by vacuum deposition.

In the case where the intermediate layer 520 includes a polymer material, the intermediate layer 520 may have a structure including an HTL and an EML. In this case, the HTL may include poly(3,4-ethylenedioxythiophene) ("PEDOT"), and the EML may include a polymer material such as a polyphenylene vinylene ("PPV")-based material and a polyfluorene-based material. The intermediate layer 520 may be formed by screen printing, inkjet printing, laser induced thermal imaging ("LITI"), or the like.

The intermediate layer 520 is not necessarily limited thereto but may have various structures. The intermediate layer 520 may include a layer, which is one body over the plurality of pixel electrodes 510, or include a layer patterned to correspond to each of the plurality of pixel electrodes 510.

The opposite electrode 530 is arranged in the display area DA and may be arranged to cover the display area DA as shown in FIG. 3. That is, the opposite electrode 530 may be formed as one body over the plurality of organic light-emitting diodes OLED and may correspond to the plurality of organic light-emitting diodes OLED. The opposite electrode 530 may include a light-transmissive conductive layer including ITO, In₂O₃, or IZO, and include a semi-transmissive layer including metal such as aluminium (Al) or silver (Ag). As an example, the opposite electrode 530 may be a semi-transmissive layer including magnesium (Mg) and silver (Ag).

A pixel-defining layer UIL may be disposed on the organic insulating layer OL. The pixel-defining layer UIL defines a pixel by including an opening corresponding to each pixel, that is, an opening exposing at least a central portion of the pixel electrode 510. In addition, as shown in FIG. 3, the pixel-defining layer UIL may prevent arcs and the like from occurring at the edges of the pixel electrode 510 by increasing a distance between the edges of the pixel electrode 510 and the opposite electrode 530. The pixel-defining layer UIL may include an organic material such as polyimide or HMDSO.

Because the organic light-emitting diode OLED may be easily damaged by external moisture, oxygen, or the like, an encapsulation layer 600 may protect the organic light-emitting diode OLED by covering the organic light-emitting diode OLED. The encapsulation layer 600 may cover the display area DA and extend to the outside of the display area DA. As shown in FIG. 3, the encapsulation layer 600 may include a first inorganic encapsulation layer 610, an organic encapsulation layer 620, and a second inorganic encapsulation layer 630.

The first inorganic encapsulation layer 610 may cover the opposite electrode 530 and may include silicon oxide, silicon nitride, and/or silicon oxynitride. When needed, other layers including a capping layer may be disposed between the first inorganic encapsulation layer 610 and the opposite electrode 530. Because the first inorganic encapsulation layer 610 is formed along a structure thereunder, the upper surface of the first inorganic encapsulation layer 610 is not flat as shown in FIG. 3. The organic encapsulation layer 620 may cover the first inorganic encapsulation layer 610 and, unlike the first inorganic encapsulation layer 610, the upper surface of the organic encapsulation layer 620 may be approximately flat. Specifically, the upper surface of a portion of the organic encapsulation layer 620 that corresponds to the display area DA may be approximately flat. The organic encapsulation layer 620 may include at least one material among polyethylene terephthalate, polyethylene naphthalate, polycarbonate, polyimide, polyethylene sulfonate, polyoxymethylene, polyarylate, and hexamethyldisiloxane. The second inorganic encapsulation layer 630 may cover the organic encapsulation layer 620 and may include silicon oxide, silicon nitride, and/or silicon oxynitride. Because the second inorganic encapsulation layer 630 contacts the first inorganic encapsulation layer 610 at the edge outside the display area DA, the organic encapsulation layer 620 may not be exposed to outside.

Because the encapsulation layer 600 includes the first inorganic encapsulation layer 610, the organic encapsulation layer 620, and the second inorganic encapsulation layer 630, even when cracks occur inside the encapsulation layer 600, the cracks may not be connected between the first inorganic encapsulation layer 610 and the organic encapsulation layer 620 or between the organic encapsulation layer 620 and the second inorganic encapsulation layer 630 through the above multi-layered structure. With this configuration, forming of a path through which external moisture or oxygen penetrates the display area DA may be prevented or reduced.

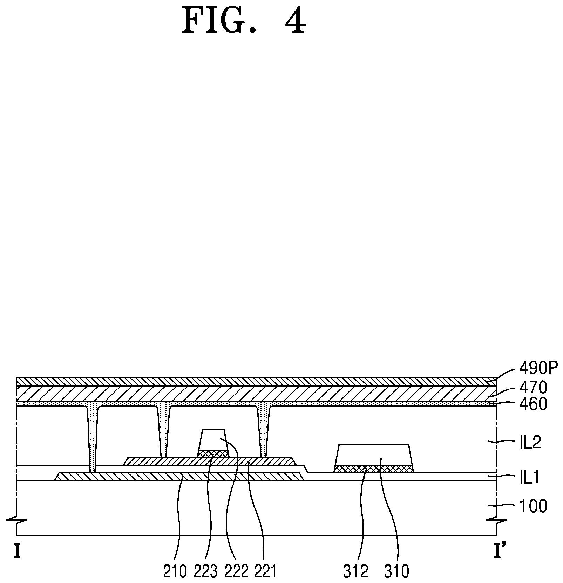

FIGS. 4 to 6 are schematic cross-sectional views showing a process of manufacturing a portion of the display apparatus 1 of FIG. 3. Specifically, FIGS. 4 to 6 are schematic cross-sectional views showing a process of manufacturing the first connection electrode 430, the second connection electrode 440, and the second electrode 420 of the display apparatus 1 of FIG. 3.

First, as shown in FIG. 4, an auxiliary layer-forming layer 460 may be formed over the substrate 100, a main metal layer-forming layer 470 may be formed on the auxiliary layer-forming layer 460, and a preliminary first protective layer-forming layer 490P may be formed on the main metal layer-forming layer 470. In the present specification, the "auxiliary layer-forming layer" denotes a layer in which the shape of an auxiliary layer 431 is not patterned after depositing an auxiliary layer-forming material, the "main metal layer-forming layer" denotes a layer in which the shape of the main metal layer 433 is not patterned after depositing a main metal-forming material, and the "preliminary first protective layer-forming layer" denotes a layer in which a portion of a first protective layer-forming material is not oxidized by oxygen and the like in the atmosphere after depositing the first protective layer-forming material.

Specifically, the auxiliary layer-forming material, the main metal layer-forming material, and the preliminary first protective layer-forming material may be successively deposited. As an example, the auxiliary layer-forming layer 460 may be formed over the substrate 100 by depositing the auxiliary layer-forming material over the entire surface of the substrate 100 by using a sputtering method or the like in a chamber. Then, the main metal layer-forming layer 470 may be formed on the auxiliary layer-forming layer 460 by depositing the main metal layer-forming material on the entire surface of the substrate 100 by using a sputtering method or the like in the same chamber. Then, the preliminary first protective layer-forming layer 490P may be formed on the main metal layer-forming layer 470 by depositing the first protective layer-forming material on the entire surface of the substrate 100 in the same chamber. However, the embodiment is not limited thereto. In another embodiment, the auxiliary layer-forming layer 460, the main metal layer-forming layer 470, and the preliminary first protective layer-forming layer 490P may be respectively formed in different chambers.

The main metal layer-forming material may include a first metal element, and the auxiliary layer-forming material may include a second metal element different from the first metal element. The first protective layer-forming material may include the first metal element and the second metal element. The first metal element may include at least one of copper (Cu), aluminium (Al), platinum (Pt), silver (Ag), gold (Au), and nickel (Ni) by taking into account conductivity or the like. The second metal element may include at least one of titanium (Ti), molybdenum (Mo), and tungsten (W). Hereinafter, for convenience of description, the case where the first metal element is Cu and the second metal element is Ti is mainly described in detail.

As an example, the main metal layer-forming material may include Cu, the auxiliary layer-forming material may include Ti, and the first protective layer-forming material may include Cu and Ti. Accordingly, the main metal layer-forming layer 470 may include Cu, the auxiliary layer-forming layer 460 may include Ti, and the preliminary first protective layer-forming layer 490P may include Cu and Ti.

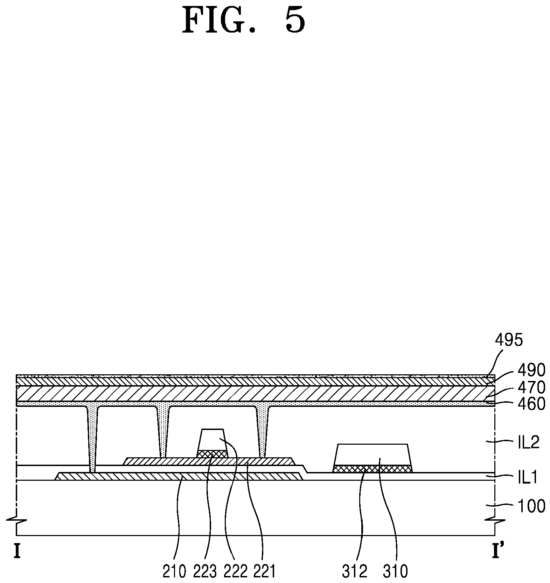

Subsequently, as shown in FIG. 5, an oxide metal layer-forming layer 495 may be formed by oxidizing a portion of the preliminary first protective layer-forming layer 490P. The first protective layer-forming layer 490 may be disposed under the oxide metal layer-forming layer 495. In the present specification, the "oxide metal layer-forming layer" is a portion of the preliminary first protective layer-forming layer 490P oxidized by oxygen or the like in the atmosphere and denotes a layer in which the shape of the oxide metal layer 438 is not patterned, and the "first protective layer-forming layer" is a portion of the preliminary first protective layer-forming layer 490P not oxidized by oxygen or the like in the atmosphere and denotes a layer in which the shape of the first protective layer 437 is not patterned. As an example, in the case where the auxiliary layer-forming layer 460, the main metal layer-forming layer 470, and the preliminary first protective layer-forming layer 490P are formed on the entire surface of the substrate 100 by using the sputtering method or the like in the same chamber, the preliminary first protective layer-forming layer 490P located in the uppermost portion of these layers may be exposed to the outside. Accordingly, Ti and Cu included in the preliminary first protective layer-forming layer 490P may be easily oxidized by oxygen in the atmosphere. Alternatively, Ti and Cu included in the preliminary first protective layer-forming layer 490P may be easily oxidized by pure water during a cleaning process using pure water before the patterning process. Accordingly, the oxide metal layer-forming layer 495 may be formed on the first protective layer-forming layer 490, wherein the oxide metal layer-forming layer 495 is formed by oxidizing a portion of the preliminary first protective layer-forming layer 490P.

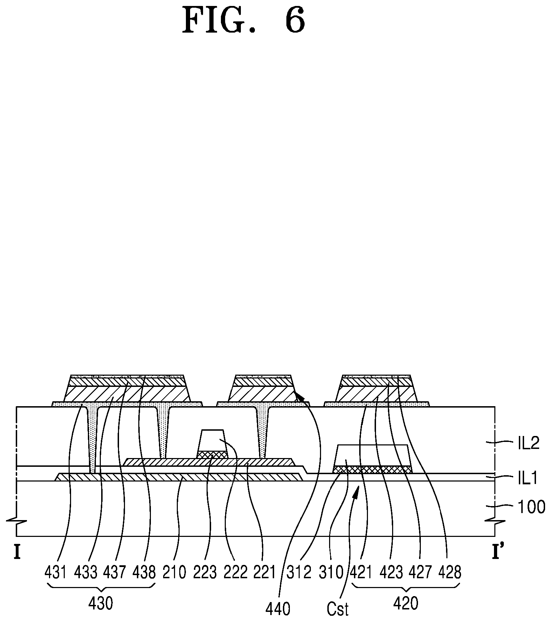

Subsequently, as shown in FIG. 6, the first connection electrode 430 including the auxiliary layer 431, the main metal layer 433, the first protective layer 437, and the oxide metal layer 438 may be formed by patterning the auxiliary layer-forming layer 460, the main metal layer-forming layer 470, the first protective layer-forming layer 490, and the oxide metal layer-forming layer 495.

The auxiliary layer-forming layer 460, the main metal layer-forming layer 470, the first protective layer-forming layer 490, and the oxide metal layer-forming layer 495 may be patterned such that the second connection electrode 440 and the second electrode 420 are formed together during the patterning process. Accordingly, like the first connection electrode 430, the second connection electrode 440 and the second electrode 420 may have a multi-layered structure. Accordingly, sub-layers 421, 423, 427, and 428 of the second electrode 420, and sub-layers of the second connection electrode 440 may respectively include the same materials as materials of the auxiliary layer 431, the main metal layer 433, the first protective layer 437, and the oxide metal layer 438, which are sub-layers of the first connection electrode 430.

Speeds at which the above forming layers are etched by etchant used during the patterning process may be different for each forming layer. Generally, a speed at which a metal layer including one metal element is etched may be different from a speed at which a metal layer including another metal element is etched. Specifically, a speed at which a metal layer including Ti is etched may be slower than a speed at which a metal layer including Cu is etched. As an example, the main metal layer-forming layer 470 may include Cu, the auxiliary layer-forming layer 460 may include Ti, and the first protective layer-forming layer 490 may include Cu and Ti. In this case, a speed at which the first protective layer-forming layer 490 is etched may be faster than a speed at which the auxiliary layer-forming layer 460 is etched. A speed at which the main metal layer-forming layer 470 is etched may be faster than a speed at which the first protective layer-forming layer 490 is etched.

Accordingly, the shapes of sub-layers 431, 433, 437, and 438 included in the first connection electrode 430 may be different from each other. Because a speed at which the main metal layer-forming layer 470 is etched is faster than a speed at which the auxiliary layer-forming layer 460 is etched, the auxiliary layer 431 may be formed to further protrude in a lateral direction (e.g., a -x direction or a +x direction) than the main metal layer 433. Here, the lateral direction may be a direction perpendicular to the thickness direction (z direction). The auxiliary layer 431 formed by this manufacturing process may include the second metal element, and the main metal layer 433 may include the first metal element.

In the case where the main metal layer-forming layer 470 includes the first metal element, and the first protective layer-forming layer 490 includes the first metal element and the second metal element, a difference between a velocity at which the main metal layer-forming layer 470 is etched and a velocity at which the first protective layer-forming layer 490 is etched may be reduced compared to the case where the main metal layer-forming layer 470 includes the first metal element, and the first protective layer-forming layer 490 includes the second metal element. That is, in the case where the main metal layer-forming layer 470 includes copper (Cu), and the first protective layer-forming layer 490 includes copper (Cu) and titanium (Ti), a difference between a velocity at which the main metal layer-forming layer 470 is etched and a velocity at which the first protective layer-forming layer 490 is etched may be reduced compared to the case where the main metal layer-forming layer 470 includes copper (Cu), and the first protective layer-forming layer 490 includes titanium (Ti).

A speed at which a metal layer including one metal element is etched may be faster than a speed at which a metal oxide layer including the same metal element as the metal element of the metal layer is etched. As an example, a speed at which a metal oxide layer including Ti and Cu is etched may be slower than a speed at which a metal layer including Ti and Cu is etched. That is, a speed at which the first protective layer-forming layer 490 is etched may be faster than a speed at which the oxide metal layer-forming layer 495 is etched.

A speed at which the metal oxide layer is etched may be different depending on a metal element included in the metal oxide layer. As an example, copper oxide (CuO_{X}) may be etched faster than titanium oxide (TiO_{X}). In the case where the oxide metal layer-forming layer 495 includes Ti and Cu, the oxide metal layer-forming layer 495 may include titanium oxide (TiO_{X}) and copper oxide (CuO_{X}). Accordingly, in the case where the oxide metal layer-forming layer 495 includes the first metal element and the second metal element, the oxide metal layer-forming layer 495 may be etched faster than the case where the oxide metal layer-forming layer 495 includes only the second metal element. That is, in the case where the oxide metal layer-forming layer 495 includes Cu and Ti, the oxide metal layer-forming layer 495 may be etched faster than the case where the oxide metal layer-forming layer 495 includes only Ti.

As described above, in the case where the first protective layer-forming layer 490 includes the first metal element and the second metal element, the first protective layer-forming layer 490 may be etched faster than the case where the first protective layer-forming layer 490 includes only the second metal element. In the case where the oxide metal layer-forming layer 495 includes the first metal element and the second metal element, the oxide metal layer-forming layer 495 may be etched faster than the case where the oxide metal layer-forming layer 495 includes only the second metal element. Accordingly, in the case where the main metal layer-forming layer 470 includes the first metal element, and the first protective layer-forming layer 490 and the oxide metal layer-forming layer 495 include the first metal element and the second metal element, a difference between a velocity at which the main metal layer-forming layer 470 is etched and a velocity at which the first protective layer-forming layer 490 and the oxide metal layer-forming layer 495 are etched may be reduced. Accordingly, a first protective layer 437 and an oxide metal layer 438 may not protrude further in a lateral direction (e.g., a - x direction or a +x direction) than the main metal layer 433. The first protective layer 437 and the oxide metal layer 438 formed by the manufacturing process may include the first metal element and the second metal element.

The second electrode 420 and the second connection electrode 440 may be formed together during a patterning process of forming the first connection electrode 430. Accordingly, the sub-layers 421, 423, 427, and 428 of the second electrode 420, and sub-layers of the second connection electrode 440 may respectively have a shape that is the same as or similar to a shape of the auxiliary layer 431, the main metal layer 433, the first protective layer 437, and the oxide metal layer 438, which are sub-layers of the first connection electrode 430.

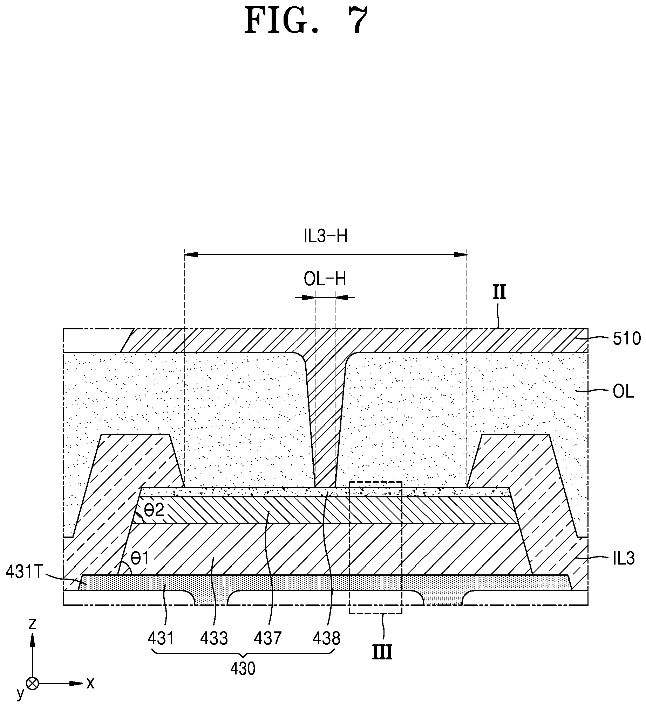

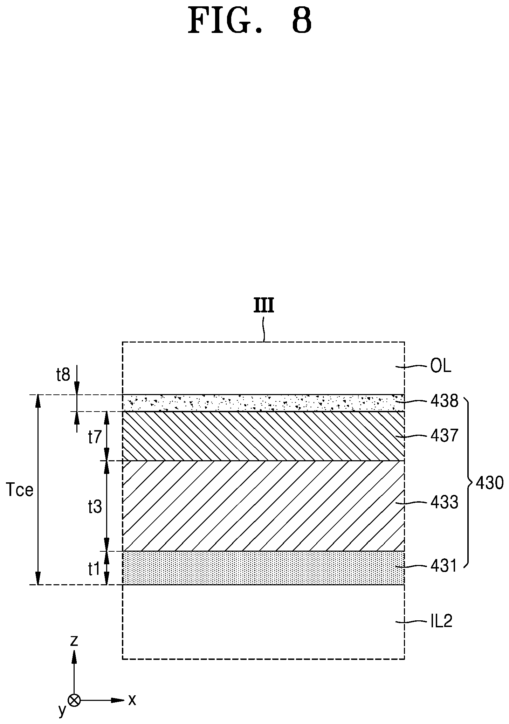

FIG. 7 is a schematic enlarged cross-sectional view of the first connection electrode 430 of the display apparatus 1 according to an embodiment, showing a region II of the display apparatus 1 of FIG. 3, and FIG. 8 is a schematic enlarged cross-sectional view of a region III of a display apparatus of FIG. 7.

As shown in FIG. 7, the first connection electrode 430 may have a multi-layered structure including a plurality of sub-layers. As an example, the first connection electrode 430 may include a main metal layer 433, a first protective layer 437, an oxide metal layer 438, and an auxiliary layer 431.

The main metal layer 433 is a sub-layer occupying most of the first connection electrode 430. When the main metal layer 433 occupies most of the first connection electrode 430, it may mean that a thickness t3 of the main metal layer 433 in a thickness direction (z direction) is 50% or more of the entire thickness Tce of the first connection electrode 430. Specifically, the thickness t3 of the main metal layer 433 may be 60% or more, or 70% or more of the entire thickness Tce of the first connection electrode 430. The thickness t3 of the main metal layer 433 may be 10 times or more of the thickness of the other layers, for example, the thickness t1 of the auxiliary layer 431 or the thickness t7 of the first protective layer 437. The thickness t3 of the main metal layer 433 may be about 3000 Angstroms (Å) to about 15000 Å. As an example, the thickness t3 of the main metal layer 433 may be about 6000 Å.

The main metal layer 433 includes the first metal element. The first metal element may include at least one of copper (Cu), aluminium (Al), platinum (Pt), silver (Ag), gold (Au), and nickel (Ni) by taking into account conductivity or the like. That is, the main metal layer 433 may include a single layer or a multi-layered structure including the first metal element. Specifically, the first metal element may include Cu. As an example, the main metal layer 433 may include a single Cu layer. However, the embodiment is not limited thereto. The main metal layer 433 may further include at least one of magnesium (Mg), indium (In), boron (B), and niobium (Nb) in another embodiment.

The first protective layer 437 is disposed on the main metal layer 433. The first protective layer 437 may be configured to prevent damage to the main metal layer 433 from an etching process included in the process of manufacturing the display apparatus. As an example, to prevent the main metal layer 433 from being damaged by etchant used during a process of etching the pixel electrode of the light-emitting diode of the display apparatus, the first protective layer 437 is disposed on the main metal layer 433.

The first protective layer 437 may include a conductive material that may protect the main metal layer 433. As an example, the first protective layer 437 includes the second metal element different from the first metal element. Specifically, the second metal element may include at least one of titanium (Ti), molybdenum (Mo), and tungsten (W). The first protective layer 437 further includes the first metal element. As an example, in the case where the main metal layer 433 includes Cu, the first protective layer 437 may further include Cu. That is, the first protective layer 437 may include an alloy of the first metal element and the second metal element. As an example, the first protective layer 437 may include an alloy of Ti and Cu. In this case, the content of the first metal element in the first protective layer 437 may be about 20 atomic percentages (at%) to about 80at%, and the content of the second metal element in the first protective layer 437 may be about 20at% to about 80at%.

A thickness t7 of the first protective layer 437 may be less than the thickness t3 of the main metal layer 433. As an example, the thickness t7 of the first protective layer 437 may be about 100Å to about 1500Å. Specifically, the thickness t7 of the first protective layer 437 may be about 300Å. The main metal layer 433 and the first protective layer 437 may be successively formed, and thus, the upper surface of the main metal layer 433 may directly contact the lower surface of the first protective layer 437. Compared to the main metal layer 433, the first protective layer 437 may further include Ti. In the case where the first protective layer 437 further includes the material not included in the main metal layer 433, a border between the main metal layer 433 and the first protective layer 437 may be identified by the material difference on the cross-section of the first connection electrode 430. However, the embodiment is not limited thereto. Because the first protective layer 437 further includes a metal element (e.g., the second metal element) not included in the main metal layer 433, a border between the main metal layer 433 and the first protective layer 437 may be identified by using the content of the second metal element. As an example, when analyzing a component in a direction (a +z direction) from the main metal layer 433 to the first protective layer 437, a section in which the content of the second metal element increases may correspond to the first protective layer 437.

The oxide metal layer 438 is disposed on the first protective layer 437. The oxide metal layer 438 is a metal oxide including the first metal element and the second metal element. As an example, in the case where the main metal layer 433 includes Cu, and the first protective layer 437 includes Cu and Ti, the oxide metal layer 438 may include CuOₓ and TiOₓ.

A thickness t8 of the oxide metal layer 438 may be less than 100Å. Because the first protective layer 437 and the oxide metal layer 438 include the same metal element (e.g., the first metal element and the second metal element), a border between the first protective layer 437 and the oxide metal layer 438 may be identified by using the content of oxygen. As an example, when analyzing a component in the direction (the +z direction) from the first protective layer 437 to the oxide metal layer 438, a section in which the content of oxygen increases may correspond to the oxide metal layer 438.

The auxiliary layer 431 may be disposed on the lower surface of the main metal layer 433, and configured to improve adhesive force between the first connection electrode 430 and a layer (e.g., the second insulating layer IL2) located under the first connection electrode 430.

The auxiliary layer 431 may include the second metal element different from the first metal element. As an example, the auxiliary layer 431 may be a metal auxiliary layer including a metal such as Ti selected by taking into account conductivity and adhesive force. The thickness t1 of the auxiliary layer 431 may be less than the thickness t3 of the main metal layer 433. As an example, the thickness t1 of the auxiliary layer 431 may be in a range from about 10Å to about 500Å. Specifically, the thickness t1 of the auxiliary layer 431 may be about 200Å.

The auxiliary layer 431 and the main metal layer 433 may be successively formed, and thus, the upper surface of the auxiliary layer 431 may directly contact the lower surface of the main metal layer 433. The auxiliary layer 431 may include Ti, and the main metal layer 433 may include Cu. In the case where the auxiliary layer 431 and the main metal layer 433 include different materials from each other as described above, a border between the auxiliary layer 431 and the main metal layer 433 may be identified by the material difference on the cross-section of the first connection electrode 430.

As shown in FIG. 7, the third insulating layer IL3 may define a first hole IL3-H therein overlapping the first connection electrode 430 in a plan view. The organic insulating layer OL may be disposed on the third insulating layer IL3 and may define a second hole OL-H therein overlapping the first hole IL3-H in a plan view. The width of a second hole OL-H of the organic insulating layer OL in a lateral direction may be different from the width of the first hole IL3-H. As an example, as shown in FIG. 7, the width of a second hole OL-H may be less than the width of the first hole IL3-H. The pixel electrode 510 may be connected to the first connection electrode 430 through the first hole IL3-H and the second hole OL-H. Thought it is shown in FIGS. 3 and 7 that the pixel electrode 510 is connected to the first connection electrode 430, the embodiment is not limited thereto. In another embodiment, the pixel electrode 510 may be connected to the second connection electrode 440.

As shown in FIG. 7, the lateral surface of the main metal layer 433 may include a tapered slope so that a cross-sectional area cut by a horizontal plane defined by x direction and y direction reduces in +z direction. Accordingly, the first connection electrode 430 having a multi-layered structure may have a tapered slope. In the case where the first connection electrode 430 has the tapered slope, step coverage of the third insulating layer IL3 on the first connection electrode 430, covering the edge of the first connection electrode 430 may be improved.

Specifically, the lateral surface of the main metal layer 433 may have a first slope angle θ1 with respect to the horizontal plane above. The first slope angle θ1 may be about 30° to about 80°. The first protective layer 437 and the oxide metal layer 438 may not protrude further in a lateral direction (e.g., a -x direction or a +x direction) than the main metal layer 433. In this case, the lateral surface of the first protective layer 437 may have a second slope angle θ2, with respect to the horizontal plane above, that is equal or similar to the first slope angle θ1, and the lateral surface of the oxide metal layer 438 may have a slope angle that is equal or similar to the first slope angle θ1.

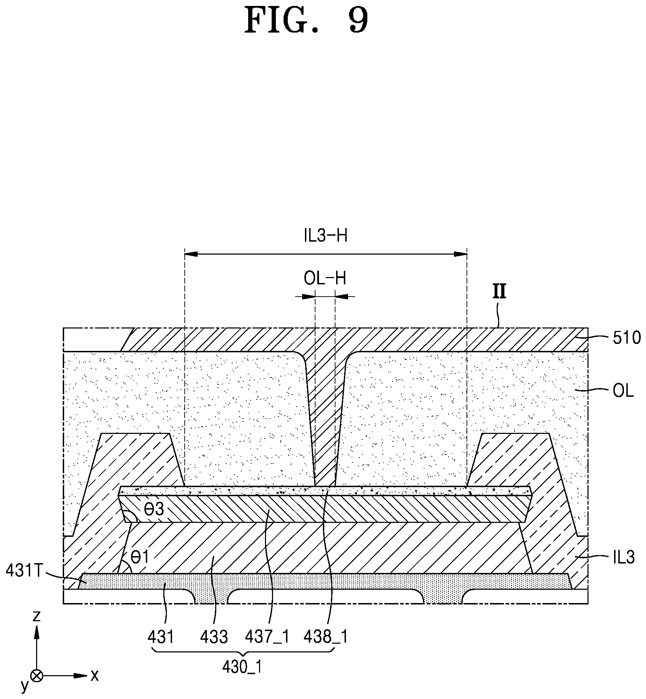

As shown in FIG. 9, which is a cross-sectional view for explaining the first connection electrode of the display apparatus according to a comparative example, in the case where the first protective layer 437_1 and the oxide metal layer 438_1 further protrude in the lateral direction (e.g., the -x direction or the +x direction) than the main metal layer 433, the first protective layer 437_1 and the oxide metal layer 438_1 may have a tip further protruding in the lateral direction (e.g., the -x direction or the +x direction) than the main metal layer 433 in their border. In this case, a slope angle θ3 of the lateral surface of the first protective layer 437_1 with respect to the horizontal plane above may exceed 90°. Accordingly, step coverage of the third insulating layer IL3 on the first connection electrode 430_1, covering the edge of the first connection electrode 430_1 may be reduced compared to the step coverage in the embodiment of FIG. 7.

However, in the display apparatus according to an embodiment, the first protective layer 437 includes the first metal element and the second metal element, and the oxide metal layer 438 includes the first metal element and the second metal element. As described above with reference to FIGS. 4 to 6, in this case, the first protective layer 437 and the oxide metal layer 438 may not further protrude in the lateral direction (e.g., the -x direction or the +x direction) than the main metal layer 433. Accordingly, the step coverage of the third insulating layer IL3 may not be reduced. Accordingly, because cracks do not occur in the third insulating layer IL3, electrical characteristics or the like of the display apparatus 1 may not be deteriorated.

In the display apparatus 1 according to an embodiment, the auxiliary layer 431 may include the second metal element. In this case, as described above with reference to FIGS. 4 to 6, the auxiliary layer 431 may be formed to further protrude in the lateral direction (e.g., the -x direction or the +x direction) than the main metal layer 433. That is, the auxiliary layer 431 may include an auxiliary layer tip 431T further protruding in the lateral direction (e.g., the -x direction or the +x direction) than a layer arranged in the neighborhood. As an example, as shown in FIG. 7, the auxiliary layer 431 may further protrude in the lateral direction (e.g., the -x direction or the +x direction) than any of the main metal layer 433, the first protective layer 437, and the oxide metal layer 438, and form the auxiliary layer tip 431T.

As described above, the auxiliary layer 431 may be disposed on the lower surface of the main metal layer 433, and configured to improve adhesive force between the first connection electrode 430 and a layer (e.g., the second insulating layer IL2) located under the first connection electrode 430. Because the auxiliary layer 431 includes the auxiliary layer tip 431T, a contact area between the auxiliary layer 431 and the second insulating layer IL2 may increase. Accordingly, adhesive force between the auxiliary layer 431 and the second insulating layer IL2 may improve. That is, adhesive force between the first connection electrode 430 and a layer located under the first connection electrode 430 may improve even more.

However, the embodiment is not limited thereto. In another embodiment, the auxiliary layer 431 may include the first metal element and the second metal element. That is, the auxiliary layer-forming layer 460 may include the first metal element and the second metal element. As an example, the auxiliary layer 431 may include an alloy of Ti and Cu. In this case, the content of the first metal element in the auxiliary layer 431 may be about 20at% to about 80at%, and the content of the second metal element in the auxiliary layer 431 may be about 20at% to about 80at%.

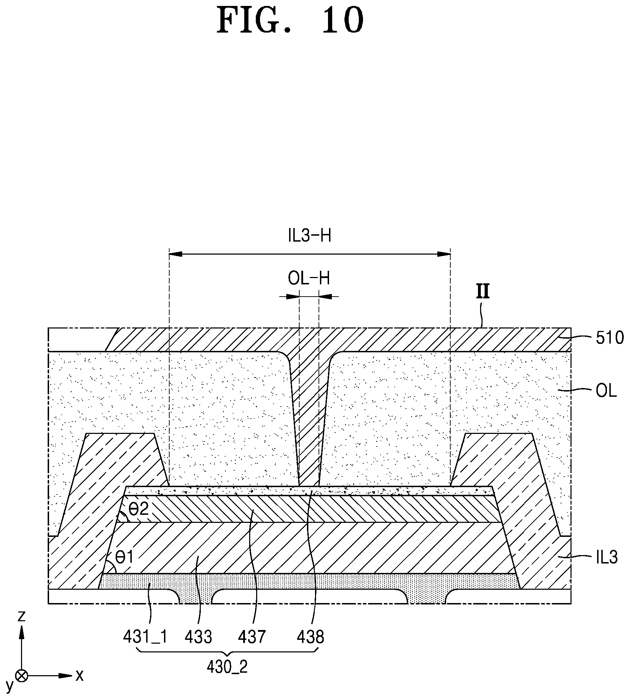

In the case where the main metal layer-forming layer 470 includes the first metal element, and the auxiliary layer-forming layer 460 includes the first metal element and the second metal element, a difference between a velocity at which the main metal layer-forming layer 470 is etched and a velocity at which the auxiliary layer-forming layer 460 is etched may be reduced compared to the case where the main metal layer-forming layer 470 includes the first metal element, and the auxiliary layer-forming layer 460 includes the second metal element. That is, in the case where the main metal layer-forming layer 470 includes copper (Cu), and the auxiliary layer-forming layer 460 includes copper (Cu) and titanium (Ti), a difference between a velocity at which the main metal layer-forming layer 470 is etched and a velocity at which the auxiliary layer-forming layer 460 is etched may be reduced compared to the case where the main metal layer-forming layer 470 includes copper (Cu), and the auxiliary layer-forming layer 460 includes titanium (Ti). As shown in FIG. 10, which is a schematic cross-sectional view of a portion of the display apparatus 1 according to an embodiment, in this case, the auxiliary layer 431_1 may not include such a tip 431T further protruding in the lateral direction (e.g., the -x direction or the +x direction) as shown in FIG. 7 than a layer arranged in the neighborhood in the border between the auxiliary layer 431_1 and the main metal layer 433. Accordingly, because an area occupied by the first connection electrode 430_2 is narrow, a space utilization may be more efficient than the embodiment of FIG. 7.

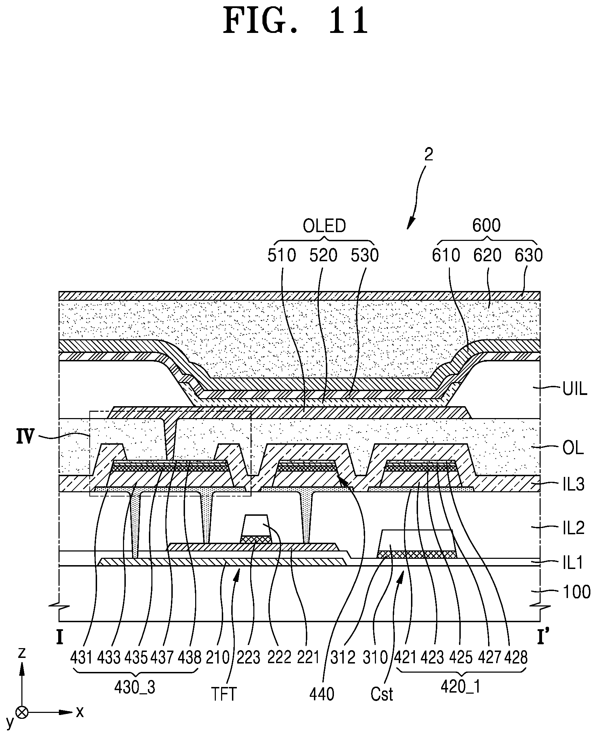

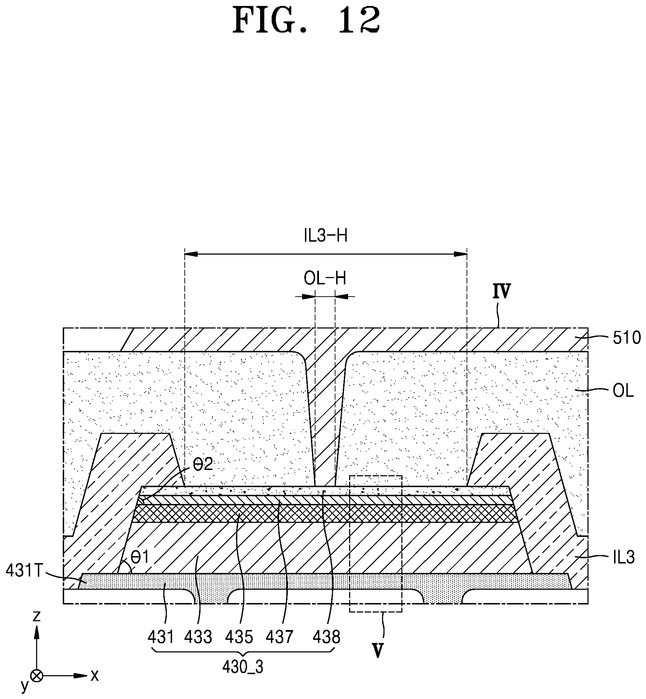

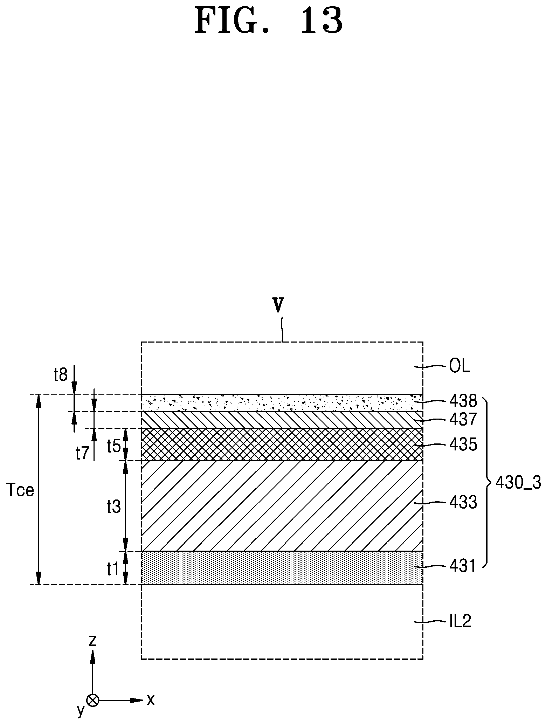

FIG. 11 is a schematic cross-sectional view of a portion of a display apparatus 2 according to another embodiment, FIG. 12 is a schematic enlarged cross-sectional view of a region IV of the display apparatus 2 of FIG. 11, and FIG. 13 is a schematic enlarged cross-sectional view of a region V of the display apparatus 2 of FIG. 12. Because the display apparatus 2 according to an embodiment is similar to the display apparatus 1 described above with reference to FIGS. 1 to 10, differences from the display apparatus 1 described with reference to FIGS. 1 to 10 are mainly described below. In FIGS. 11 to 13, the same reference numerals as those of FIGS. 1 to 10 denote the same members, and thus, repeated descriptions thereof are omitted.

As shown in FIGS. 11 and 12, the first connection electrode 430_3 of the display apparatus 2 may include the main metal layer 433, a second protective layer 435, the first protective layer 437, the oxide metal layer 438, and the auxiliary layer 431. That is, compared to the first connection electrode 430 included in the display apparatus 1, the first connection electrode 430_3 included in the display apparatus 2 further includes the second protective layer 435. Because the descriptions of the main metal layer 433, the first protective layer 437, the oxide metal layer 438, and the auxiliary layer 431 included in the display apparatus 1 are applicable to the main metal layer 433, the first protective layer 437, the oxide metal layer 438, and the auxiliary layer 431 in the display apparatus 2, repeated descriptions associated with these are omitted.

The second protective layer 435 is disposed between the main metal layer 433 and the first protective layer 437. The second protective layer 435 may be configured to prevent etchant from progressing toward the main metal layer 433 through cracks, if any, that may occur in the first protective layer 437. The second protective layer 435 includes a different material from the main metal layer 433. As an example, the second protective layer 435 includes the second metal element. As described above, the second metal element may include at least one of titanium (Ti), molybdenum (Mo), and tungsten (W). That is, the second protective layer 435 may include a metal layer including metal elements such as Ti, Mo, and/or W. The second protective layer 435 may include a single layer or a multi-layered structure including the second metal element. In an embodiment, the second protective layer 435 may have a single-layered structure such as a titanium layer, a molybdenum layer, or a tungsten layer. Alternatively, the second protective layer 435 may have a multi-layered structure in which these layers are stacked.

Like the second connection electrode 440 and the second electrode 420 included in the display apparatus 1, the second connection electrode 440 and the second electrode 420_1 included in the display apparatus 2 may include a multi-layered structure as in the first connection electrode 430_3. Accordingly, sub-layers 421, 423, 425, 427, and 428 of the second electrode 420_1, and sub-layers of the second connection electrode 440 may respectively include the same materials as materials of the auxiliary layer 431, the main metal layer 433, the second protective layer 435, the first protective layer 437, and the oxide metal layer 438, which are sub-layers of the first connection electrode 430_3.

A thickness t5 of the second protective layer 435 may be less than the thickness t3 of the main metal layer 433. As an example, the thickness t5 of the second protective layer 435 may be about 100Å to about 1500Å. Specifically, the thickness t5 of the second protective layer 435 may be about 300Å. In the case where the display apparatus 2 includes the second protective layer 435, the thickness t7 of the first protective layer 437 included in the display apparatus 2 may be less than 100Å. That is, the thickness t5 of the second protective layer 435 of the display apparatus 2 may be greater than the thickness t7 of the first protective layer 437 of the display apparatus 2. However, the embodiment is not limited thereto and the thickness t7 of the first protective layer 437 of the display apparatus 2 may be greater than the thickness t5 of the second protective layer 435 of the display apparatus 2.

As shown in FIG. 12, the second protective layer 435 may not further protrude in the lateral direction (e.g., the -x direction or the +x direction) than the main metal layer 433. In this case, the lateral surface of the second protective layer 435 may have a slope angle equal or similar to the first slope angle θ1. The lateral surface of the main metal layer 433 may have the first slope angle θ1 of about 30° to about 80°, and the lateral surface of the second protective layer 435, the lateral surface of the first protective layer 437, and the lateral surface of the oxide metal layer 438 may have a slope angle equal or similar to the first slope angle θ1. Accordingly, like the first connection electrode 430 of the display apparatus 1, the first connection electrode 430_3 of the display apparatus 2 may have a tapered slope surface by and large.

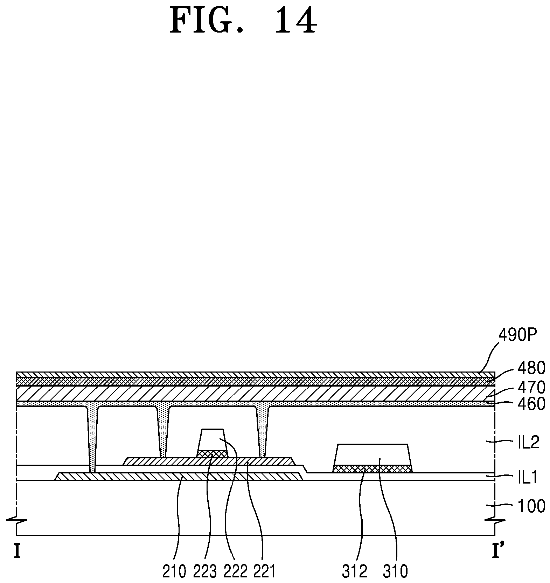

FIGS. 14 to 16 are schematic cross-sectional views showing a process of manufacturing a portion of the display apparatus 2 of FIG. 11. Specifically, FIGS. 14 to 16 are schematic cross-sectional views showing a process of manufacturing the first connection electrode 430_3, the second connection electrode 440, and the second electrode 420_1 of the display apparatus 2 of FIG. 11. Because a process of manufacturing the display apparatus 2 is similar to the process of manufacturing the display apparatus 1 described above with reference to FIGS. 4 to 6, differences from the process of manufacturing the display apparatus 1 described above with reference to FIGS. 4 to 6 are mainly described below. In FIGS. 14 to 16, the same reference numerals as those of FIGS. 4 to 6 denote the same members, and thus, repeated descriptions thereof are omitted.

First, as shown in FIG. 14, the auxiliary layer-forming layer 460 may be formed over the substrate 100, and the main metal layer-forming layer 470 may be formed on the auxiliary layer-forming layer 460. Then, a second protective layer-forming layer 480 may be formed on the main metal layer-forming layer 470, and a preliminary first protective layer-forming layer 490P may be formed on the second protective layer-forming layer 480. In the present specification, the second protective layer-forming layer denotes a layer in which the shape of the second protective layer 435 is not patterned after a second protective layer-forming material is deposited.

Specifically, the auxiliary layer-forming material, the main metal layer-forming material, the second protective layer-forming material, and the first protective layer-forming material may be successively deposited. As an example, the auxiliary layer-forming layer 460 may be formed over the substrate 100 by depositing the auxiliary layer-forming material over the entire surface of the substrate 100 by using a sputtering method or the like in a chamber. Then, the main metal layer-forming layer 470 may be formed on the auxiliary layer-forming layer 460 by depositing the main metal layer-forming material on the entire surface of the substrate 100 by using a sputtering method or the like in the same chamber. Then, the second protective layer-forming layer 480 may be formed on the main metal layer-forming layer 470 by depositing the second protective layer-forming material on the entire surface of the substrate 100 in the same chamber. Then, the preliminary first protective layer-forming layer 490P may be formed on the second protective layer-forming layer 480 by depositing the first protective layer-forming material on the entire surface of the substrate 100 in the same chamber. However, the embodiment is not limited thereto. In another embodiment, the auxiliary layer 431, the main metal layer 433, the second protective layer 435, and the first protective layer 437 may be respectively formed in different chambers.

The second protective layer-forming material may include the second metal element different from the first metal element. As described above, the second metal element may include at least one of titanium (Ti), molybdenum (Mo), and tungsten (W). The second protective layer-forming material may not include the first metal element. Hereinafter, for convenience of description, the case where the second protective layer-forming material includes Ti as the second metal element is mainly described in detail.

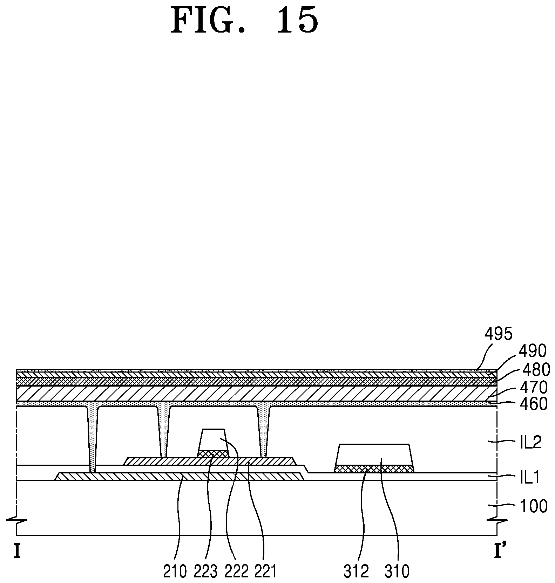

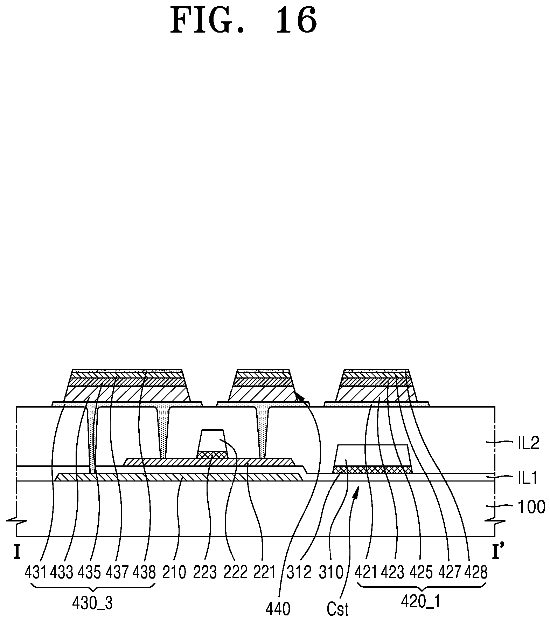

Subsequently, as shown in FIG. 15, the oxide metal layer-forming layer 495 may be formed by oxidizing a portion of the preliminary first protective layer-forming layer 490P. As described above, because the preliminary first protective layer-forming layer 490P is exposed to the outside, Ti and Cu included in the preliminary first protective layer-forming layer 490P may be easily oxidized by oxygen or the like in the atmosphere. Accordingly, the oxide metal layer-forming layer 495 may be formed on the first protective layer-forming layer 490, wherein the oxide metal layer-forming layer 495 is formed by oxidizing a portion of the preliminary first protective layer-forming layer 490P. Subsequently, as shown in FIG. 16, the first connection electrode 430_3 may be formed by patterning the auxiliary layer-forming layer 460, the main metal layer-forming layer 470, the second protective layer-forming layer 480, the first protective layer-forming layer 490, and the oxide metal layer-forming layer 495, wherein the first connection electrode 430_3 includes the auxiliary layer 431, the main metal layer 433, the second protective layer 435, the first protective layer 437, and the oxide metal layer 438.

As described above, a speed at which the metal layer including one metal element is etched may be different from a speed at which the metal layer including another metal element is etched. Accordingly, because the main metal layer-forming layer 470 including Cu may be etched faster than the auxiliary layer-forming layer 460 including Ti, the auxiliary layer 431 may be formed to further protrude in the lateral direction (e.g., the -x direction or the +x direction) than the main metal layer 433.

The second protective layer-forming layer 480 includes Ti, but the second protective layer 435 may not be formed to further protrude in the lateral direction (e.g., the -x direction or the +x direction) than the main metal layer 433. Because the first protective layer-forming layer 490 formed on the second protective layer-forming layer 480 includes Ti and Cu, the first protective layer-forming layer 490 may be etched faster than the second protective layer-forming layer 480. In addition, the oxide metal layer-forming layer 495 may include TiOₓ and CuOₓ. In this case, the oxide metal layer-forming layer 495 may be etched faster than the case where the oxide metal layer-forming layer 495 includes only TiOₓ. Furthermore, because the oxide metal layer-forming layer 495 is located in the uppermost portion while the patterning is performed, and an area contacting the etchant is large, the etching of the oxide metal layer-forming layer 495 may be fast. Accordingly, the first protective layer-forming layer 490 and the oxide metal layer-forming layer 495 formed on the second protective layer-forming layer 480 may be etched faster than the second protective layer-forming layer 480.

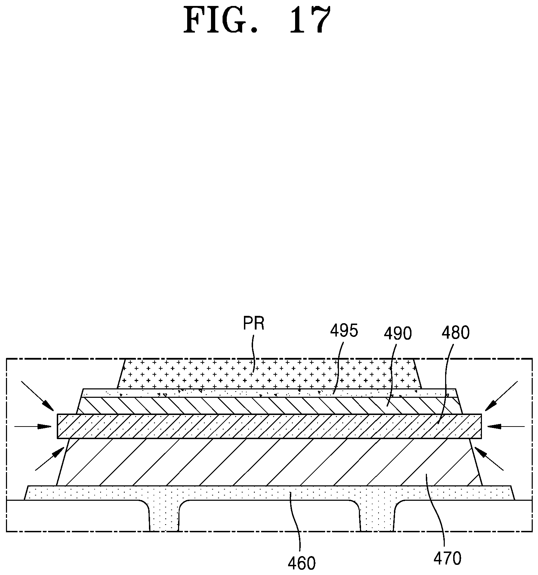

FIG. 17 is a view for explaining a portion of a second protective layer-forming layer that contacts etchant while patterning is performed. While the pattern is performed, a photoresist PR may be located on the oxide metal layer-forming layer 495. The main metal layer-forming layer 470 may be etched faster than the second protective layer-forming layer 480. Accordingly, in the case where the first protective layer-forming layer 490 and the oxide metal layer-forming layer 495 formed on the second protective layer-forming layer 480 are etched faster than the second protective layer-forming layer 480, the lateral surface of the second protective layer-forming layer 480 and the upper surface and the lower surface adjacent to the lateral surface may contact the etchant as shown in FIG. 17. That is, the second protective layer-forming layer 480 may contact the etchant on three surfaces. In this case, the second protective layer-forming layer 480 may be etched faster than the case where the second protective layer-forming layer 480 contacts the etchant on two surfaces.

In the case where the first protective layer-forming layer 490 and the oxide metal layer-forming layer 495 formed on the second protective layer-forming layer 480 are etched slower than the second protective layer-forming layer 480, the second protective layer-forming layer 480 may contact the etchant on two surfaces. That is, the second protective layer-forming layer 480 may contact the etchant on only the lateral surface of the second protective layer-forming layer 480 and the lower surface adjacent to the lateral surface.

In contrast, in the display apparatus 2 according to an embodiment, the first protective layer-forming layer 490 and the oxide metal layer-forming layer 495 formed on the second protective layer-forming layer 480 may be etched faster than the second protective layer-forming layer 480. Accordingly, because the second protective layer 435 is etched fast, the second protective layer 435 may not be formed to further protrude in the lateral direction (e.g., the -x direction or the +x direction) than the main metal layer 433. Accordingly, the step coverage of the third insulating layer IL3 may not be reduced. Because cracks do not occur in the third insulating layer IL3, electrical characteristics or the like of the display apparatus 2 may not be deteriorated.

According to an embodiment, the display apparatus including high-quality connection electrodes with electrical characteristics not deteriorated while the connection electrodes are not damaged during a subsequent process after the connection electrode is formed may be implemented. However, the scope of the present disclosure is not limited by this effect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (1) comprising:
a substrate (100) including a display area (DA) and a peripheral area (PA) outside the display area (DA);
a display element arranged in the display area (DA);
a transistor (TFT) including a semiconductor layer (221) and a gate electrode (222); and
a connection electrode (430) electrically connected to the transistor (TFT) and having a multi-layered structure,
wherein the connection electrode (430) includes:
a main metal layer (433) including a first metal element; and
a first protective layer (437) disposed on the main metal layer (433) and including the first metal element and a second metal element different from the first metal element;
**characterised in that** the connection electrode (430) further comprises an oxide metal layer (438) disposed on the first protective layer (437) and including a metal oxide including the first metal element and the second metal element.

2. The display apparatus (1) of claim 1, wherein the first metal element includes at least one of copper (Cu), aluminium (Al), platinum (Pt), silver (Ag), gold (Au), and nickel (Ni).

3. The display apparatus (1) of claim 2, wherein the second metal element includes at least one of titanium (Ti), molybdenum (Mo), and tungsten (W).

4. The display apparatus (1) of claim 3, wherein the first protective layer (437) includes an alloy of copper (Cu) and titanium (Ti).

5. The display apparatus (1) of any one of claims 1 to 4, further comprising an auxiliary layer (431) disposed under the main metal layer (433).

6. The display apparatus (1) of claim 5, wherein the auxiliary layer (431) includes the second metal element.

7. The display apparatus (1) of claim 6, wherein:
(i) the auxiliary layer (431) includes an auxiliary layer tip (431T) further protruding in a lateral direction than the main metal layer (433) at a border between the auxiliary layer (431) and the main metal layer (433); and/or
(ii) the auxiliary layer (431) further includes the first metal element.

8. The display apparatus of any one of claims 1 to 7, further comprising:
a second protective layer (435) disposed between the main metal layer (433) and the first protective layer (437) and including the second metal element.

9. The display apparatus (1) of any one of claims 1 to 8, wherein the semiconductor layer (221) is disposed on the substrate (100),
the gate electrode (222) is disposed on a gate insulating layer (223) disposed on the semiconductor layer (221), and
the connection electrode (430) is electrically connected to the semiconductor layer (221).

## Patentansprüche

1. Anzeigeeinrichtung (1), umfassend:
ein Substrat (100), das einen Anzeigebereich (DA) und einen Randbereich (PA) außerhalb des Anzeigebereichs (DA) einschließt,
ein im Anzeigebereich (DA) eingerichtetes Anzeigeelement;
einen Transistor (TFT) einschließlich einer Halbleiterschicht (221) und einer Gate-Elektrode (222); und
eine Verbindungselektrode (430), die elektrisch mit dem Transistor (TFT) verbunden ist und eine Mehrschichtstruktur aufweist,
wobei die Verbindungselektrode (430) einschließt:
eine Hauptmetallschicht (433), die ein erstes Metallelement einschließt; und
eine erste Schutzschicht (437), die auf der Hauptmetallschicht (433) angeordnet ist und das erste Metallelement sowie ein zweites, vom ersten Metallelement verschiedenes Metallelement einschließt;
**dadurch gekennzeichnet, dass** die Verbindungselektrode (430) weiter eine Oxidmetallschicht (438) umfasst, die auf der ersten Schutzschicht (437) angeordnet ist und ein Metalloxid einschließt, das das erste Metallelement und das zweite Metallelement einschließt.

2. Anzeigeeinrichtung (1) nach Anspruch 1, wobei das erste Metallelement mindestens eines der folgenden Metalle einschließt: Kupfer (Cu), Aluminium (Al), Platin (Pt), Silber (Ag), Gold (Au) und Nickel (Ni).

3. Anzeigeeinrichtung (1) nach Anspruch 2, wobei das zweite Metallelement mindestens eines der Metalle Titan (Ti), Molybdän (Mo) und Wolfram (W) einschließt.

4. Anzeigeeinrichtung (1) nach Anspruch 3, wobei die erste Schutzschicht (437) eine Legierung aus Kupfer (Cu) und Titan (Ti) einschließt.

5. Anzeigeeinrichtung (1) nach einem der Ansprüche 1 bis 4, weiter umfassend eine Hilfsschicht (431), die unter der Hauptmetallschicht (433) angeordnet ist.

6. Anzeigeeinrichtung (1) nach Anspruch 5, wobei die Hilfsschicht (431) das zweite Metallelement einschließt.

7. Anzeigeeinrichtung (1) nach Anspruch 6, wobei
(i) die Hilfsschicht (431) eine Hilfsschichtspitze (431T ) einschließt, die an einer Grenze zwischen der Hilfsschicht (431) und der Hauptmetallschicht (433) seitlich weiter vorsteht als die Hauptmetallschicht (433); und/oder
(ii) die Hilfsschicht (431) weiter das erste Metallelement einschließt.

8. Anzeigeeinrichtung nach einem der Ansprüche 1 bis 7, weiter umfassend:
eine zweite Schutzschicht (435), die zwischen der Hauptmetallschicht (433) und der ersten Schutzschicht (437) angeordnet ist und das zweite Metallelement einschließt.

9. Anzeigeeinrichtung (1) nach einem der Ansprüche 1 bis 8, wobei die Halbleiterschicht (221) auf dem Substrat (100) angeordnet ist,
die Gate-Elektrode (222) auf einer Gate-Isolierschicht (223) angeordnet ist, die auf der Halbleiterschicht (221) angeordnet ist, und
die Verbindungselektrode (430) elektrisch mit der Halbleiterschicht (221) verbunden ist.

## Revendications

1. Appareil d'affichage (1) comprenant :
un substrat (100) incluant une zone d'affichage (DA) et une zone périphérique (PA) à l'extérieur de la zone d'affichage (DA),
un élément d'affichage agencé dans la zone d'affichage (DA) ;
un transistor (TFT) incluant une couche semi-conductrice (221) et une électrode de grille (222) ; et
une électrode de connexion (430) connectée électriquement au transistor (TFT) et présentant une structure multicouche,
dans lequel l'électrode de connexion (430) inclut :
une couche métallique principale (433) incluant un premier élément métallique ; et
une première couche protectrice (437) disposée sur la couche métallique principale (433) et incluant le premier élément métallique et un deuxième élément métallique différent du premier élément métallique ;
**caractérisé en ce que** l'électrode de connexion (430) comprend en outre une couche métallique d'oxyde (438) disposée sur la première couche protectrice (437) et incluant un oxyde métallique incluant le premier élément métallique et le deuxième élément métallique.

2. Appareil d'affichage (1) selon la revendication 1, dans lequel le premier élément métallique inclut au moins l'un de cuivre (Cu), d'aluminium (Al), de platine (Pt), d'argent (Ag), d'or (Au) et de nickel (Ni).

3. Appareil d'affichage (1) selon la revendication 2, dans lequel le deuxième élément métallique inclut au moins l'un de titane (Ti), de molybdène (Mo) et de tungstène (W).

4. Appareil d'affichage (1) selon la revendication 3, dans lequel la première couche protectrice (437) inclut un alliage de cuivre (Cu) et de titane (Ti).

5. Appareil d'affichage (1) selon l'une quelconque des revendications 1 à 4, comprenant en outre une couche auxiliaire (431) disposée sous la couche métallique principale (433).

6. Appareil d'affichage (1) selon la revendication 5, dans lequel la couche auxiliaire (431) inclut le deuxième élément métallique.

7. Appareil d'affichage (1) selon la revendication 6, dans lequel
(i) la couche auxiliaire (431) inclut une pointe de couche auxiliaire (431T) qui fait saillie davantage dans une direction latérale que la couche métallique principale (433) à une frontière entre la couche auxiliaire (431) et la couche métallique principale (433) ; et/ou
(ii) la couche auxiliaire (431) inclut en outre le premier élément métallique.

8. Appareil d'affichage selon l'une quelconque des revendications 1 à 7, comprenant en outre :
une deuxième couche protectrice (435) disposée entre la couche métallique principale (433) et la première couche protectrice (437) et incluant le deuxième élément métallique.

9. Appareil d'affichage (1) selon l'une quelconque des revendications 1 à 8, dans lequel la couche semi-conductrice (221) est disposée sur le substrat (100),
l'électrode de grille (222) est disposée sur une couche isolante de grille (223) disposée sur la couche semi-conductrice (221), et
l'électrode de connexion (430) est connectée électriquement à la couche semi-conductrice (221).
